# EUROPEAN PATENT APPLICATION

(11) **EP 0 557 004 A2**
(43) Date of publication of application: **25.08.1993**
(21) Application number: 93300956.5
(22) Date of filing: 10.02.1993
(51) Int. Cl.: G06F 15/72, G03F 1/04

(54) **Apparatus and method for electronic impositioning**

(30) Priority: 17.02.1992 IL 100980
(71) Applicant: SCITEX CORPORATION LTD., Herzliya 46103 (IL)
(72) Inventor: Bieber, Avigdor, Ra'anana (IL); Wrobel, Victor, Hod Hasharon (IL); Barak, Paltiel, Givatayim (IL); Carlebach, Ephraim N., Ra'anana (IL); Braunold, Michael, Ra'anana (IL)
(74) Representative: Hillier, Peter

(57) **Abstract**

Apparatus and method for exposing at least a portion of a fully imposed flat is described. The apparatus includes a) apparatus for creating a plurality of partial flats forming sections of the portion of the fully imposed flat, the partial flats being described in a first page description language, b) apparatus for converting the plurality of partial flats from the first to a second page description language, thereby creating a plurality of converted partial flats and c) large format exposing apparatus, having an initial exposure position, for sequentially receiving and exposing the plurality of converted partial flats and for returning to the initial exposure position only after exposure of the entirety of the plurality of converted partial flats.

## Description

### FIELD OF THE INVENTION

The present invention relates to imposition systems generally and to imposition systems for color separations in particular.

### BACKGROUND OF THE INVENTION

The production of a book or magazine involves a large number of processes. The processes may be grouped into five general categories: prepress, plate preparation, press set up or "make ready"; press control operations; and postpress operations.

In prepress, the principal processes are graphics, image and text editing and composition. In recent years, this area has undergone revolutionary changes through application of computer technology. State of the art systems for graphics and image editing and composition are known as Color Electronic Prepress Systems (CEPS), an example of which is the RESPONSE system manufactured by Scitex Corporation Ltd., Herzlia, Israel.

Systems for scanning, image processing and plotting include systems manufactured and sold by Scitex Corporation Ltd., such as, respectively, the systems sold under the trademarks Smart Scanner, Assembler and Raystar.

Plate preparation involves a technique known as imposition or signature assembly, which refers to the arrangement of pages on films used to produce a printing plate. A "signature" typically refers to the information on both sides of a printing plate. A "flat" typically refers to the information on one side of a printing plate.

The present state of the art in signature assembly is the use of large and expensive machinery requiring highly skilled operators. Presently available signature assembly machinery involves the following steps: exposure of each of a plurality of separations (such as Cyan, Magenta, Yellow and Black (CMYK)) for each of a plurality of pages to be arranged on a single plate; and subsequently, for each separation, such as C, feeding the exposed plurality of pages to an expose and repeat device such as the Misomex Master S Series, commercially available from Misomex North America Inc., Rosemont, Illinois. The expose and repeat device is operative to arrange the plurality of exposed C separations, corresponding to the plurality of pages to be arranged on a single plate, at precisely determined positions on a plate ready film and to reproduce the C separations at the precisely determined positions by a photographic process.

The C printing plate is produced by contact exposure of the plate ready film. The signature is proofed prior to exposure of the plate. The plate, once exposed, is often found to be imperfect and therefore generally requires quality inspection and defect repair processes. The plate preparation process is repeated in order to produce M, Y and K plates.

Various processes in the production of printed matter are discussed in the following publications, the disclosures of which are incorporated herein by reference:

Alfred Furler, Folding in Practice, in collaboration with STAHL GMBH & Co., 3rd Edition, Germany, 1983;

William Schreiber, Fundamentals of Electronic Imaging Systems, Springer-Verlag, New York, 1986;

R. K. Molla, Electronic Color Separation, RK Publications, 1988; and

Michael H. Brill (Ed.), Perceiving, Measuring and Using Color, SPIE Proceedings, Vol. 1250, Billingham, Washington, USA, Feb. 1990;

Robert A. Ulicheney, Digital Halftoning and Physical Reconstruction Function, Ph.D. Thesis, Massachusetts Institute of Technology, MA, USA, June 1986; and

Raymond Blair and Charles Shapiro (Eds.), The Lithographer's Manual, GATF, USA, 1980.

Computer technology has also been proposed for use in facilitating certain stages of the imposition process as described in European Published Patent Application 0309196, published March 29, 1989, European Published Patent Application 0348908, published January 3, 1990 and in U.K. Patent 2128843, published on May 2, 1984. U.S. Patent 4,150,991 describes one type of optical imposition machine employing transparencies.

A procedure known as "electronic stripping" has been devised in order to improve the generation of plate ready films. Electronic stripping involves generating plate ready films directly on a large format exposure unit. Typically, pages are designed on any suitable system and are provided to an impositioning workstation, such as a MACINTOSH manufactured by Apple Computer Corporation of the U.S.A. The workstation creates an impositioned flat from the page information and provides the flat to the large format exposure unit.

The impositioning workstation typically includes impositioning software, such as IMPOSTRIP manufactured by Ultimate Technographics of Montreal, Canada and IMPOSITION PUBLISHER manufactured by Farrukh Systems of the London, United Kingdom.

The impositioning software determines the proper orientation and location for each of the pages in a flat and determines which pages are associated with which flat.

If the exposure unit can only expose a portion of the plate ready films, then the impositioning software performs "tiling" and splits the plate ready film into at least two films, each forming part of the plate ready film, to be prepared as described hereinabove for signature assembly.

The impositioning software typically receives pages created on any type of image generation system and defined in a portable page description language, such as POSTSCRIPT defined by Adobe Systems of Mountainview, Ca, U.S.A. The software produces flats described in POSTSCRIPT.

However, since POSTSCRIPT is typically not the "native" page description language of the exposure unit, the flats have to be converted into the native page description language of the exposure unit before exposure can take place.

Since the conversion operation is very time-consuming, electronic stripping for complex images can take longer than manual stripping.

### SUMMARY OF THE INVENTION

It is therefore an object of the present invention to provide a system enabling exposure of images described in a portable page description language by a large format exposure unit.

There is therefore provided, in accordance with an embodiment of the present invention, apparatus for exposing at least a portion of a fully imposed flat. The apparatus includes a) apparatus for creating a plurality of partial flats forming sections of the portion of the fully imposed flat and b) large format exposing apparatus, having an initial exposure position, for sequentially receiving and exposing the plurality of partial flats and for returning to the initial exposure position only after exposure of the entirety of the plurality of partial flats.

There is also provided, in accordance with an embodiment of the present invention, apparatus for exposing at least a portion of a fully imposed flat. The apparatus includes a) apparatus for creating a plurality of partial flats forming sections of the portion of the fully imposed flat, the partial flats being described in a first page description language, b) apparatus for converting the plurality of partial flats from the first to a second page description language, thereby creating a plurality of converted partial flats and c) large format exposing apparatus, having an initial exposure position, for sequentially receiving and exposing the plurality of converted partial flats and for returning to the initial exposure position only after exposure of the entirety of the plurality of converted partial flats.

Additionally, in accordance with an embodiment of the present invention, the apparatus for converting includes more than one apparatus for converting operating in parallel.

Moreover, in accordance with an embodiment of the present invention, the large format exposing apparatus includes apparatus for receiving a plurality of offset distances corresponding to locations of the plurality of converted partial flats, wherein the first offset distance is the initial exposure position, and apparatus for beginning exposure of each of the converted partial flats at its corresponding offset distance.

Further, in accordance with an embodiment of the present invention, the apparatus for converting includes apparatus for determining the plurality of offset distances.

There is additionally provided, in accordance with an embodiment of the present invention, a method for exposing at least a portion of a fully imposed flat. The method includes the steps of a) creating a plurality of partial flats forming sections of the portion of the fully imposed flat and b) sequentially receiving and exposing the plurality of partial flats, beginning at an initial exposure position and returning to it only after exposure of the entirety of the plurality of partial flats.

There is further provided, in accordance with an embodiment of the present invention, an additional method for exposing at least a portion of a fully imposed flat. The method includes the steps of a) creating a plurality of partial flats forming sections of the portion of the fully imposed flat, the partial flats being described in a first page description language, b) converting the plurality of partial flats from the first to a second page description language, thereby creating a plurality of converted partial flats and c) sequentially receiving and exposing the plurality of converted partial flats, beginning at an initial exposure position and returning to it only after exposure of the entirety of the plurality of converted partial flats.

Additionally, in accordance with an embodiment of the present invention, the step of receiving and exposing includes the steps of a) receiving a plurality of offset distances corresponding to locations of the plurality of converted partial flats wherein the first offset distance is the initial exposure position and b) beginning exposure of each of the converted partial flats at its corresponding offset distance.

Finally, in accordance with an embodiment of the present invention, the step of converting includes the step of determining the plurality of offset distances.

### BRIEF DESCRIPTION OF THE DRAWING

The present invention will be understood and appreciated more fully from the following detailed description taken in conjunction with the drawings and annexes in which:

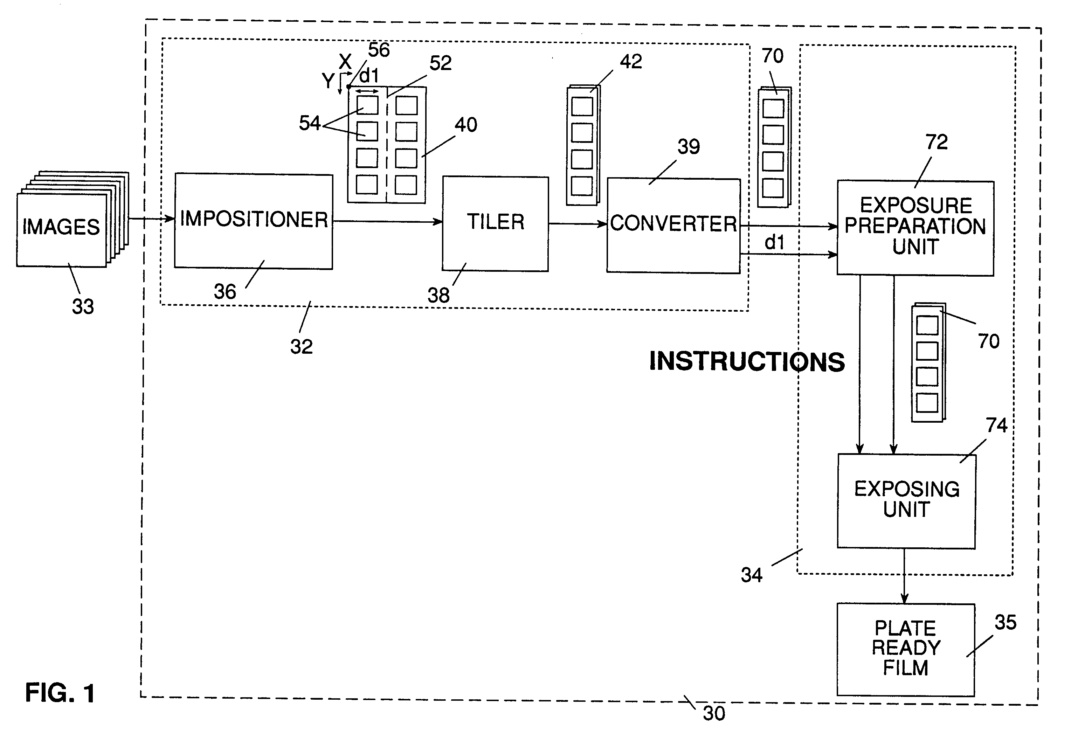

Fig. 1 is a block diagram illustration of a system for electronic stripping using a low end color generation system and an impositioning system, constructed and operative in accordance with a preferred embodiment of the present invention.

### DETAILED DESCRIPTION OF PRESENT INVENTION

Reference is now made to Fig. 1 which illustrates a system 30 for electronic stripping, constructed and operative in accordance with a preferred embodiment of the present invention.

The system 30 typically comprises an impositioning system 32 which is a slightly modified version of prior art impositioning workstations, and a large format exposure unit 34, such as the Dolev 800 manufactured by Scitex Corporation Ltd. of Herzlia, Israel, for producing plate ready films 35.

The impositioning system 32 typically receives images 33 in a portable page description language, such as POSTSCRIPT, either from an outside color generation system or from a color generation system resident on the same platform as the impositioning system. The large format exposure unit 34 typically receives data in a second page description language, such as the Continuous Tone and Linework format defined by Scitex Corporation Ltd.

The impositioning system 32 typically comprises an impositioner 36 for receiving the images 33 and for imposing them into a fully imposed flat 40 defined in the portable page description language, a tiler 38 for dividing flat 40 into at least two partial flats 42 and a converter 39 for converting the two flats 40 into the second page description language. Typically, the impositioner 36 and the tiler 38 are features of a single impositioning package, such as IMPOSTRIP, and the converter 39 is similar to the Visionary Interpreter for Postscript manufactured by Scitex Corporation Ltd.

In accordance with the present invention, the tiler 38 typically splits flat 40 along at least one line 52 preferably parallel to the scanning direction of the large format exposure unit 34 and between two rows or columns of images 54 on the fully imposed flat 40. Each line 52 is typically offset a distance dᵢ, where i ranges from 1 to the number of lines 52, from an initial scanning location 56 of exposure unit 34. For exposure units 34 scanning in the y direction, the at least one line 52 is offset from the leftmost, uppermost corner of the fully imposed flat 40.

The at least two partial flats 42 are provided to converter 39 which converts them to the second page description language. In accordance with a preferred embodiment of the present invention, the converter 39 also retrieves the offsets dᵢ from the information stored in the partial flat 42. The coordinates, relative to the initial scanning location of the exposure unit 34, of the offsets dᵢ are stored in each partial flat 42. For large format exposure units 34 whose native page description language is the portable page description language, converter 39 is operative to determine the offsets dᵢ.

If desired, the converter 39 can comprise two generally identical converters 39 for processing the two partial flats 42 in parallel.

The output of the converter 39, converted partial flats 70, are provided to an exposure preparation unit 72 for preparing the converted partial flats 70 for exposure. For the first partial flat 70, unit 72 directly provides the partial flat 70 to an exposing unit 74 for exposure.

Upon completion of the exposure of the first partial flat 70, the exposing unit 74 is not returned to its initial position, as in the prior art.

Instead, the exposure preparation unit 72 directs the exposing unit 74 to move to the location indicated by offset d₁. Unit 72 then provides the exposing unit 74 with the second partial flat 70.

The above operations are repeated, with the appropriate dᵢ substituted for d₁, for the remainder of partial flats 70. Once they have all been exposed, the exposure preparation unit 72 directs the exposing unit 74 to return to its initial position. The exposing unit 74 thus generates the plate ready film 35 of a single color separation comprised of the entirety of exposed partial flats 70 of a single separation. The process is repeated for each color separation.

It will be appreciated that the present invention exposes at least part of an imposed flat 40, for each color separation, by exposing the entirety of its tiled partial flats 42 without combining the tiled partial flats 42 into a single data file.

It will be appreciated by persons skilled in the art that the present invention is not limited to what has been particularly shown and described hereinabove. Rather the scope of the present invention is defined only by the claims which follow:

## Claims

1. Apparatus for exposing at least a portion of a fully imposed flat, the apparatus comprising:
means for creating a plurality of partial flats forming sections of said portion of said fully imposed flat; and
large format exposing means, having an initial exposure position, for sequentially receiving and exposing said plurality of partial flats and for returning to said initial exposure position only after exposure of the entirety of the plurality of partial flats.

2. Apparatus for exposing at least a portion of a fully imposed flat, the apparatus comprising:
means for creating a plurality of partial flats forming sections of said portion of said fully imposed flat, said partial flats being described in a first page description language;
means for converting said plurality of partial flats from said first to a second page description language, thereby creating a plurality of converted partial flats; and
large format exposing means, having an initial exposure position, for sequentially receiving and exposing said plurality of converted partial flats and for returning to said initial exposure position only after exposure of the entirety of the plurality of converted partial flats.

3. Apparatus according to claim 2 and wherein said means for converting includes more than one means for converting operating in parallel.

4. Apparatus according to claim 2 and wherein said large format exposing means comprises:
means for receiving a plurality of offset distances corresponding to locations of said plurality of converted partial flats wherein the first offset distance is the initial exposure position; and
means for beginning exposure of each of said converted partial flats at its corresponding offset distance.

5. Apparatus according to claim 4 and wherein said means for converting includes means for determining said plurality of offset distances.

6. Apparatus according to claim 1 and wherein said large format exposing means comprises:
means for receiving a plurality of offset distances corresponding to locations of said plurality of partial flats wherein the first offset distance is the initial exposure position; and
means for beginning exposure of each of said partial flats at its corresponding offset distance.

7. Apparatus according to claim 6 and wherein said means for converting includes means for determining said plurality of offset distances.

8. A method for exposing at least a portion of a fully imposed flat, the method comprising the steps of:
creating a plurality of partial flats forming sections of said portion of said fully imposed flat; and
sequentially receiving and exposing said plurality of partial flats, beginning at an initial exposure position and returning to it only after exposure of the entirety of the plurality of partial flats.

9. A method for exposing at least a portion of a fully imposed flat, the method comprising the steps of:
creating a plurality of partial flats forming sections of said portion of said fully imposed flat, said partial flats being described in a first page description language;
converting said plurality of partial flats from said first to a second page description language, thereby creating a plurality of converted partial flats; and
sequentially receiving and exposing said plurality of converted partial flats, beginning at an initial exposure position and returning to it only after exposure of the entirety of the plurality of converted partial flats.

10. A method according to claim 9 and wherein said step of receiving and exposing comprises the steps of:
receiving a plurality of offset distances corresponding to locations of said plurality of converted partial flats wherein the first offset distance is the initial exposure position; and
beginning exposure of each of said converted partial flats at its corresponding offset distance.

11. A method according to claim 10 and wherein said step of converting includes the step of determining said plurality of offset distances.

12. A method according to claim 7 and wherein said step of receiving and exposing comprises the steps of:
receiving a plurality of offset distances corresponding to locations of said plurality of partial flats wherein the first offset distance is the initial exposure position; and
beginning exposure of each of said partial flats at its corresponding offset distance.

13. A method according to claim 12 and wherein said step of converting includes the step of determining said plurality of offset distances.
